# EUROPÄISCHE PATENTSCHRIFT

(11) **EP 0 837 553 B1**
(45) Veröffentlichungstag und Bekanntmachung des Hinweises auf die Patenterteilung: **14.11.2001**
(21) Anmeldenummer: 97115375.4
(22) Anmeldetag: 04.09.1997
(51) Int. Cl.: H02P 6/14

(54) **Ansteuerschaltung für einen bürstenlosen Gleichstrommotor**
Drive circuit for a commutatorless dircet current motor
Circuit de commande pour un moteur à courant continu sans balais

(30) Priorität: 18.10.1996 DE 29618133 U
(43) Veröffentlichungstag der Anmeldung: 22.04.1998
(73) Patentinhaber: Papst-Motoren GmbH & Co. KG, 78112 St. Georgen (DE)
(72) Erfinder: Doemen, Benno, D-78112 St.Georgen (DE)
(74) Vertreter: Patentanwälte Dr. Solf & Zapf

(56) Entgegenhaltungen:
- EP-A- 0 538 204
- DE-A- 1 806 620
- DE-A- 2 633 047
- DE-A- 2 642 472
- US-A- 4 594 535
- H.D. STÖLTING A. BEISSE: "ELEKTRISCHE KLEINMASCHINEN" 1987 , TEUBNER , STUTTGART XP002052722 * Seite 188, Absatz 6.4; Abbildungen 6.33-6.34 *

## Beschreibung

Die vorliegende Erfindung betrifft eine Ansteuerschaltung für einen bürstenlosen, elektronisch kommutierten Gleichstrommotor, wobei in Reihe mit jedem Wicklungsstrang des Motors ein elektronisches Schaltelement angeordnet ist und die Schaltelemente in Abhängigkeit von einem - insbesondere als digital schaltender Hall-IC ausgebildeten - Rotor-Drehstellungssensor angesteuert werden, und wobei jeder Wicklungsstrang über jeweils eine Auskoppeldiode mit einem gemeinsamen Schaltungspunkt verbunden ist, wobei parallel zu den Wicklungssträngen und den zugehörigen Auskoppeldioden eine Schutztransistorschaltung angeordnet ist, die derart ausgelegt ist und über den gemeinsamen Schaltungspunkt derart angesteuert wird, daß induktionsbedingte Spannungsspitzen eliminiert (kurzgeschlossen) werden, und wobei ein Schutztransistor mit seiner Kollektor-Emitter-Strecke parallel zu den Wicklungssträngen und den zugehörigen Auskoppeldioden geschaltet ist.

Eine derartige Ansteuerschaltung ist aus der DE-A-26 42 472 bekannt, wobei der Schutztransistor als Darlington-Transistor aus zwei kaskadierten gewöhnlichen Transistoren aufgebaut ist. Der Darlington-Transistor ist mit seiner Basis mit einem gemeinsamen Anschlußpunkt zwischen einem Reihenwiderstand und einer Zenerdiode verbunden, wobei die Zenerdiode einerseits an dem gemeinsamen Schaltungspunkt der Auskoppeldioden angeschlossen und andererseits über den Reihenwiderstand mit einem Sternpunkt der Wicklungsstränge verbunden ist.

Die US-A-4,594,535 beschreibt einen Motor mit einer ähnlichen Ansteuerschaltung, die ebenfalls einen Darlington-Transistor aufweist, dessen Kollektor-Emitter-Strecke allerdings den gemeinsamen Schaltungspunkt der Auskoppeldioden gegen Masse schaltet, also nicht im gattungsgemäßen Sinne parallel zu den Wicklungen und den Auskoppeldioden geschaltet ist.

Weitere Arten von Ansteuerschaltungen sind ebenfalls bekannt; lediglich beispielsweise sei auf das Fachbuch "Elektrische Kleinstmotoren und ihr Einsatz" von Helmut Moczala u.a., expert verlag/VDE-Verlag 1979, und darin vor allem Seiten 174 und 183, hingewiesen. Die Auskoppeldioden dienen dabei dazu, aus den jeweils stromlosen Wicklungssträngen die aufgrund der Rotation induzierte Spannung abzuleiten, die als rein drehzahlabhängiges Steuersignal (Tachometerspannung) zur Drehzahlregelung einem Regler zugeführt werden kann (Drehzahl-Istwertsignal). Als Rotor-Drehstellungsensoren werden heute bevorzugt digital schaltende Hall-IC verwendet und nur noch seltener analoge Hall-Generatoren. Aufgrund des digitalen Schaltungsverhaltens werden jeweils im Abschaltmoment in dem jeweiligen Wicklungsstrang auch durch Selbstinduktion (Gegeninduktion) sehr hohe Spannungsspitzen U = - L (di/dt) erzeugt, die in mehrfacher Hinsicht nachteilig sind. Vor allem führen sie zu einer hohen Verlustleistung in den elektronischen Schaltelementen, so daß diese entsprechend größer bzw. leistungsstärker ausgelegt werden müssen, als es eigentlich für die jeweilige Motorleistung erforderlich wäre. Dies führt nachteiligerweise zu höheren Bauteilkosten. Grundsätzlich wäre es möglich, einen größeren Glättungskondensator für die Steuerspannung vorzusehen, wodurch aber die Regeldynamik verschlechtert werden würde. Ein ebenfalls bekannter Lösungsversuch, eine Bedämpfung der Schaltelemente durch sogenannte Miller-Kondensatoren jeweils von Kollektor nach Basis vorzusehen, führt zu einem verschlechterten Wirkungsgrad, da die bewirkte Schaltverzögerung bei der Rotation des Motors zu Bremsströmen führt.

Der vorliegenden Erfindung liegt die Aufgabe zugrunde, eine gattungsgemäße Ansteuerschaltung so zu verbessern, daß unter Verwendung von einfachen und preiswerten Bauteilen ein guter Wirkungsgrad und - falls eine Regelung vorgesehen ist - auch eine gute Regeldynamik gewährleistet sind.

Erfindungsgemäß wird dies dadurch erreicht, daß die Basis des Schutztransistors über einen Steuerkondensator mit dem gemeinsamen Schaltungspunkt verbunden ist.

Mit der erfindungsgemäßen Schaltung wird bei Auftreten eines steilen Spannungsanstieges U = - L (di/dt) im über die Auskoppeldiode aus dem jeweiligen Wicklungsstrang abgeleiteten Signal über die Schutztransistorbeschaltung die Spannungspitze kurzgeschlossen bzw. auf den eigentlichen Wert der im jeweils stromlosen Wicklungsstrang induzierten EMK begrenzt.

Der erfindungsgemäße Steuerkondensator kann vorteilhafterweise eine geringe Kapazität besitzen, so daß es sich um ein preisgünstiges Bauteil handelt (insbesondere in Relation zu einem sonst eventuell erforderlichen, sehr viel größeren Glättungskondensator). Aufgrund des Verstärkungsfaktors des Schutztransistors wirkt aber virtuell eine sehr viel größere Kapazität, dies jedoch vorteilhafterweise auch ohne entsprechend viel Energie zu speichern. Dies wirkt sich sehr günstig für das dynamische Verhalten aus. Wenn sich beispielsweise durch den Schutztransistor ein Verstärkungsfaktor von etwa 400 ergibt, wirkt virtuell eine Kapazität, die um den Faktor 400 größer als der Steuerkondensator ist.

Die Erfindung eignet sich vor allem für eine Ansteuerschaltung mit Regler, wobei das über die Auskoppeldioden gewonnene Signal (EMK) als drehzahlabhängige Tachometerspannung einem Regler zugeführt wird. Die Erfindung ist jedoch auch ohne Regler sehr vorteilhaft, weil durch die Eliminierung der schädlichen Spannungsspitzen als Kommutierungs-Schaltelemente vergleichsweise einfache und preiswerte Transistoren mit geringer Leistung verwendet werden können. Denn die erfindungsgemäße Schutztransistorbeschaltung begrenzt die Kollektor-Emitter-Spannung U_{CE} der Kommutierungstransistoren optimal auf U_{B} und U_{E} = U_{CE}. Miller Kondensatoren oder dergleichen zum Verlangsamen der Schaltflanken sind vorteilhafterweise nicht erforderlich, so daß auch die Verlustleistung der Kommutierungstransistoren reduziert und der Motorwirkungsgrad verbessert wird.

Weitere vorteilhafte Ausgestaltungsmerkmale der Erfindung sind in den Unteransprüchen sowie der folgenden Beschreibung enthalten.

Anhand von zwei in der Zeichnung dargestellten, bevorzugten Ausführungsbeispielen soll im folgenden die Erfindung näher erläutert werden. Dabei zeigen:
- Fig. 1: eine erfindungsgemäße Ansteuerschaltung mit Regler und
- Fig. 2: eine erfindungsgemäße Ansteuerschaltung ohne Regler.

Die Ausführungsbeispiele beziehen sich auf einen bürstenlosen Gleichstrommotor mit zwei Wicklungssträngen L₁ und L₂. Die Erfindung ist jedoch nicht auf einen zweisträngigen Motor beschränkt. In Reihe mit jedem Wicklungsstrang L₁, L₂ ist ein elektronisches Schaltelement T₁, T₂ angeordnet. Zur Kommutierung der Wicklungsstränge werden die Schaltelemente T₁, T₂ in Abhängigkeit von den Ausgangssignalen eines Rotor-Drehstellungssensors 2 angesteuert. Dieser Drehstellungssensor 2 ist bevorzugt als digital schaltender Hall-IC ausgebildet. Der Drehstellungssensor 2 steuert die Schaltelemente T₁, T₂ direkt bzw. über einen Inverter 4 (Transistor plus Widerstand) an. Hierdurch können die Wicklungsstränge L₁ oder L₂ zur Kommutierung alternativ eingeschaltet werden, wodurch dann aufgrund der Betriebsspannung U_{B} ein Motorstrom fließt.

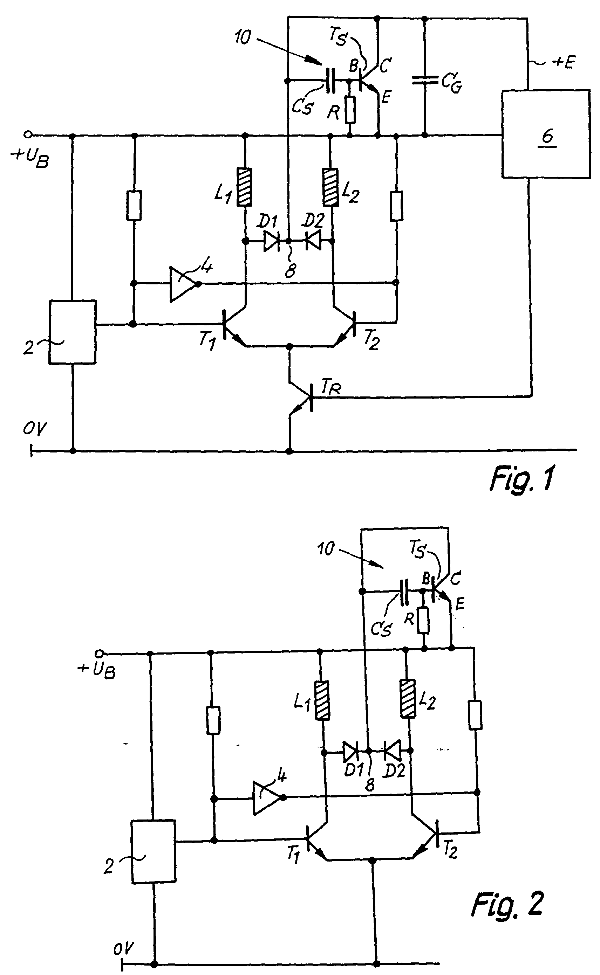

Bei der Ausführungsform nach Fig. 1 ist ein (Drehzahl-) Regler vorgesehen, dem als drehzahlabhängiges Signal E die in dem jeweils stromlosen Wicklungsstrang induzierte Gegen-EMK zugeführt wird. Dieses Signal wird aus den Wicklungssträngen L₁ bzw. L₂ über Auskoppeldioden D₁, D₂ abgeleitet und über einen gemeinsamen Schaltungspunkt 8 dem Regler 6 zugeführt. Der Regler 6 ist mit einem Regeltransistor T_{R} verbunden, der im dargestellten Ausführungsbeispiel nach Fig. 1 bevorzugt als Längsregler mit seiner Kollektor-Emitter-Strecke in Reihe zu den Schaltelementen T₁, T₂ angeordnet ist.

Weiterhin ist eine Schutztransistorbeschaltung 10 vorgesehen, die parallel zu den Wicklungssträngen L₁, L₂ und den zugehörigen Auskoppeldionen D₁, D₂ geschaltet ist. Die Schutztransistorbeschaltung 10 weist einen Schutztransistor T_{S} auf, der mit seiner Kollektor-Emitter-Strecke C-E parallel zu den Wicklungssträngen und den zugehörigen Auskoppeldioden geschaltet ist. Die Basis B des Schutztransistors T_{S} ist erfindungsgemäß über einen Steuerkondensator C_{S} mit dem gemeinsamen Schaltungspunkt 8 zwischen den Auskoppeldioden verbunden. Zudem liegt parallel zur Basis-Emitter-Strecke B-E des Schutztransistors T_{S} ein Widerstand R. Erfindungsgemäß ist nun vorgesehen, daß der Steuerkondensator C_{S} und/oder der Schutztransistor T_{S} derart ausgelegt sind/ist, daß induktionsbedingte, d.h. jeweils im Moment des Abschaltens des jeweiligen Wicklungsstranges durch Gegen-Induktion auftretende Spannungsspitzen U = - L (di/dt) über den Schutztransistor T_{S} eliminiert, d.h. kurzgeschlossen werden. Hierdurch wird die verbleibende Spannung auf die jeweils induzierte EMK begrenzt.

Wie sich ferner aus Fig. 1 ergibt, kann parallel zur Kollektor-Emitter-Strecke C-E des Schutztransistors T_{S} ein Glättungskondensator C_{G} angeordnet sein. Aufgrund der erfindungsgemäßen Schutztransistorbeschaltung 10 kann dieser Glättungskondensator C_{G} eine vergleichsweise geringe Kapazität aufweisen oder sogar gänzlich entbehrlich sein.

In Fig. 2 ist die Ansteuerschaltung ohne Regler dargestellt. Das über den gemeinsamen Schaltungspunkt 8 abgegriffene Signal wird hierbei folglich nicht als Tachometerspannung benötigt, sondern es dient ausschließlich im Zusammenhang mit der erfindungsgemäßen Schutztransistorbeschaltung 10 dazu, die schädlichen Spannungsspitzen zu eliminieren. Die Schutztransistorbeschaltung 10 entspricht hierbei der Ausführung nach Fig. 1.

Im folgenden sei beispielhaft ein konkreter Anwendungsfall erläutert. Bei einem z.B. für ein Handrührgerät vorgesehenen Motor mit 24 V Betriebsspannung U_{B} und ca. 150 mA Stromaufnahme hat der Steuerkondensator C_{S} bevorzugt eine Kapazität von etwa 100 nF, und der Widerstand R beträgt etwa 12 kΩ. Als Schutztransistor T_{S} kann ein sehr preiswerter Kleinsignaltransistor verwendet werden, beispielsweise BC 847. Dieser Transistor wird thermisch kaum belastet, weil er die meiste Zeit gesperrt ist und nur für die kurze Zeit der Wicklungsstrang-Abschaltspitze leitend wird.

Falls gemäß Fig. 1 auch ein Glättungskondensator C_{G} vorgesehen ist, so hat dieser bevorzugt ebenfalls eine Kapazität von etwa 100 nF. Hierzu sei bemerkt, daß ohne die erfindungsgemäße Maßnahme an dieser Stelle ein Glättungskondensator mit einer sehr viel höheren, im *µ*F-Bereich liegenden Kapazität (beispielsweise 2,2 *µ*F) erforderlich wäre.

## Patentansprüche

1. Ansteuerschaltung für einen bürstenlosen, elektronisch-kommutierten Gleichstrommotor, wobei in Reihe mit jedem Wicklungsstrang (L₁, L₂) des Motors ein elektronisches Schaltelement (T₁, T₂) angeordnet ist und die Schaltelemente (T₁, T₂) in Abhängigkeit von einem - insbesondere als digitaler Hall-IC ausgebildeten - Rotor-Drehstellungssensor (2) angesteuert werden, wobei jeder Wicklungsstrang (L₁, L₂) über jeweils eine Auskoppeldiode (D₁, D₂) mit einem gemeinsamen Schaltungspunkt (8) verbunden ist, wobei parallel zu den Wicklungssträngen (L₁, L₂) und den zugehörigen Auskoppeldioden (D₁, D₂) eine Schutztransistorbeschaltung (10) angeordnet ist, die derart angesteuert wird, daß induktionsbedingte Spannungsspitzen eliminiert werden, wobei die Schutztransistorbeschaltung (10) einen Schutztransistor (T₂) aufweist, der mit seiner Kollektor-Emitter-Strecke (C-E) parallel zu den Wicklungssträngen (L₁, L₂) und den zugehörigen Auskoppeldioden (D₁, D₂) geschaltet ist,
**dadurch gekennzeichnet, daß** die Basis (B) des Schutztransistors (T₂) über einen Steuerkondensator (C_{S}) mit dem gemeinsamen Schaltungspunkt (8) verbunden ist.

2. Ansteuerschaltung nach Anspruch 1,
**gekennzeichnet durch** einen zur Basis-Emitter-Strecke (B-E) des Schutztransistors (T₂) parallelen Widerstand (R).

3. Ansteuerschaltung nach Anspruch 1 oder 2,
**dadurch gekennzeichnet, daß** der gemeinsame Schaltungspunkt (8) mit einem Steuerspannungseingang (+E) eines Reglers (6) verbunden ist.

4. Ansteuerschaltung nach Anspruch 3,
**dadurch gekennzeichnet, daß** der Regler (6) einen Regel-Endstufentransistor (T_{R}) aufweist, der insbesondere als Längsregler in Reihe mit den Schaltlementen (T₁, T₂) geschaltet ist.

5. Ansteuerschaltug nach Anspruch 3 oder 4,
**dadurch gekennzeichnet, daß** parallel zur Kollektor-Emitter-Strecke (C-E) des Schutztransistors (T₂) ein Glättungskondensator (C_{G}) angeordnet ist.

## Claims

1. Drive circuit for a brushless, electronically commutated DC motor, with electronic switching elements (T₁, T₂) being arranged in series with each winding section (L₁, L₂) of the motor, and the switching elements (T₁, T₂) being driven as a function of a rotor rotation position sensor (2) - in particular in the form of a digital Hall-IC - with each winding section (L₁, L₂) being connected to a common circuit point (8) via a respective output diode (D₁, D₂), with a protection transistor circuit (10) being arranged in parallel with the winding sections (L₁, L₂) and the associated output diodes (D₁, D₂) and being driven in such a manner that voltage spikes caused by induction are eliminated, with the protection transistor circuit (10) having a protection transistor (T₂) whose collector-emitter path (C-E) is connected in parallel with the winding sections (L₁, L₂) and the associated output diodes (D₁, D₂),
**characterized in that** the base (B) of the protection transistor (T₂) is connected to the common circuit point (8) via a control capacitor (C_{S}).

2. Drive circuit according to Claim 1,
**characterized by** a resistor (R) in parallel with the base-emitter junction (B-E) of the protection transistor (T₂).

3. Drive circuit according to Claim 1 or 2,
**characterized in that** the common circuit point (8) is connected to a control voltage input (+E) of a regulator (6).

4. Drive circuit according to Claim 3,
**characterized in that** the regulator (6) has a regulation output stage transistor (T_{R}) which, in particular, as a series regulator, is connected in series with the switching elements (T₁, T₂).

5. Drive circuit according to Claim 3 or 4,
**characterized in that** a smoothing capacitor (C_{G}) is arranged in parallel with the collector-emitter path (C-E) of the protection transistor (T₂).

## Revendications

1. Circuit de commande pour un moteur à courant continu sans balais, à commutation électronique, dans lequel un élément de commutation électronique (T₁, T₂) est disposé en série avec chaque branche d'enroulement (L₁, L₂) du moteur et les éléments de commutation (T₁, T₂) sont commandés en fonction d'un détecteur (2) de position angulaire du rotor - constitué en particulier par un circuit imprimé à effet Hall numérique - dans lequel chaque branche d'enroulement (L₁, L₂) est connectée à un point commun (8) du circuit à travers une diode de découplage respective (D₁, D₂), cependant qu'en parallèle avec les branches d'enroulement (L₁, L₂) et avec leurs diodes de découplage (D₁, D₂) est disposé un circuit de protection à transistor (10) qui est commandé de manière que les pointes de tension dues à l'induction soient éliminées, le circuit de protection à transistor (10) comprenant un transistor de protection (T₂) dont le circuit collecteur-émetteur (C-E) est connecté en parallèle avec les branches d'enroulement (L₁, L₂) et avec leurs diodes de découplage (D₁, D₂),
**caractérisé en ce que** la base (B) du transistor de protection (T₂) est connectée au point commun (8) du circuit à travers un condensateur de commande (C_{S}).

2. Circuit de commande selon la revendication 1,
**caractérisé par** une résistance (R) en parallèle avec le circuit base-émetteur (B-E) du transistor de protection (T₂).

3. Circuit de commande selon la revendication 1 ou 2,
**caractérisé en ce que** le point commun (8) du circuit est relié à une entrée de tension de commande (+E) d'un régulateur (6).

4. Circuit de commande selon la revendication 3, **caractérisé en ce que** le régulateur (6) comprend un transistor d'étage final de régulation (T_{R}) qui est connecté en série avec les éléments de commutation (T₁, T₂), en particulier en qualité de régulateur longitudinal.

5. Circuit de commande selon la revendication 3 ou 4,
**caractérisé en ce qu'**un condensateur de filtrage (C_{G}) est connecté en parallèle avec le circuit collecteur-émetteur (C-E) du transistor de protection (T₂).
